# EUROPEAN PATENT SPECIFICATION

(11) **EP 2 205 773 B1**
(45) Date of publication and mention of the grant of the patent: **12.11.2014**
(21) Application number: 08830338.3
(22) Date of filing: 11.09.2008
(51) Int. Cl.: C23C 14/06, C23C 14/58, C23C 14/56

(54) **METHOD AND APPARATUS FOR THERMALLY CONVERTING METALLIC PRECURSOR LAYERS INTO SEMICONDUCTING LAYERS**
VERFAHREN UND VORRICHTUNG ZUR THERMISCHEN UMWANDLUNG METALLISCHER VORLÄUFERSCHICHTEN IN HALBLEITERSCHICHTEN
PROCÉDÉ ET APPAREIL POUR CONVERTIR THERMIQUEMENT DES COUCHES PRÉCURSEURS MÉTALLIQUES EN COUCHES SEMICONDUCTRICES

(30) Priority: 11.09.2007 DE 102007043051; 01.10.2007 DE 102007047098; 01.10.2007 DE 102007047099; 08.10.2007 DE 102007048204
(43) Date of publication of application: 14.07.2010
(73) Proprietor: Centrotherm Photovoltaics AG, 89143 Blaubeuren (DE)
(72) Inventor: SCHMID, Dieter, 80933 München (DE); LENZ, Reinhard, 89143 Blaubeuren (DE); HARTUNG, Robert, Michael, 89143 Blaubeuren (DE)
(74) Representative: Heyerhoff Geiger & Partner Patentanwälte
(86) International application number: PCT/EP2008/007466
(87) International publication number: WO 2009/033674

(56) References cited:
- EP-A- 1 424 735
- WO-A-2005/086238
- WO-A-2008/085604
- JP-A- 2001 049 432

## Description

The present invention concerns a Method for thermally converting metallic precursor layers on substrates into semiconducting layers, and also an apparatus for carrying out the method and for producing solar modules on substrates.

Such convertible metallic layers, which are also referred to as precursor layers, can contain copper, gallium and indium. The precursor layer can be applied to the substrate, which can be a glass substrate, by means of known technologies, e.g. by sputtering. For the conversion into semiconducting CIGS layers (CIGS: copper indium gallium selenide), so-called chalcogens, that is to say selenium, sulphur, tellurium and compounds thereof among one another or with other substances or mixtures thereof, have to be supplied onto said layers. At room temperature, that is to say around 20°C, said chalcogens assume a solid state of matter and evaporate at temperatures above approximately 350°C. Such glass substrates prepared with a CIGS layer can then be processed further as blanks to form solar modules, this including various contact-connections and, if appropriate, the application of passivations, filter layers, etc.

What is essential for a good efficiency is for the precursor layer to be converted as completely as possible into the CIGS layer with an identical layer thickness over the area.

According to the prior art, methods for thermally converting these prepared precursor layers into semiconducting layers have been disclosed which proceed either under vacuum, or else under atmospheric conditions with the supply of hydrogen-containing gases (EP 0 318 315 A2), but in return are very time-consuming and costly. Typical conversion temperatures are 550°C.

The problem in the vacuum processes is the long conversion time (also called process time). In industrial conversion this leads to problems because long process times are always accompanied by low productivity. One solution would be, on the one hand, to use many machines simultaneously, but this would mean high costs in terms of capital expenditure, or else, on the other hand, to accelerate the processes. However, the prior art does not offer any indications in respect thereof.

EP 0 662 247 B1 has disblosed a method for producing a chalcopyrite semiconductor on a substrate, in which the substrate prepared with metals, such as copper, indium or gallium, is heated in an inert process gas to a process temperature of at least 350°C at a heating rate of at least 10°-C/second. The process temperature is maintained for a time period of 10 seconds to 1 hour, in which the substrate is exposed to sulphur or selenium as a component in excess relative to the components copper, indium or gallium. For this purpose, a covering is situated above the layer construction on the substrate at a distance of less than 5 mm in the sense of an encapsulation. In this case, the partial pressure of sulphur or selenium lies above the partial pressure that would form over a stoichiometrically exact composition of the starting components copper, indium or gallium and sulphur.

EP 1 424 735 shows the heat treatment of a substrate having a metal precursor layer under low pressure within a selenide environment to convert the precursor into a semiconductor layer.

WO 2005/086238 describes a chamber having separated heating elements to anneal copper indium gallium diselenide solar cells.

The invention is based on the object, then, of providing an accelerated and simple-to-realize fast method for thermally converting metallic layers on any desired substrates into semiconducting layers, and also an apparatus suitable for carrying out the method and serving for producing solar modules with high efficiency.

This is achieved by means of a method comprising the features of claim 1.

The substrates previously prepared at least with a metallic precursor layer are heated in a furnace, which is segmented into different temperature regions, at a pressure at approximately atmospheric ambient pressure in a plurality of steps in each case to a predetermined temperature up to the end temperature between 400°C and 600°C and are converted into semiconducting layers whilst maintaining the end temperature in an atmosphere comprising a mixture of a carrier gas and vaporous chalcogens.

The substrates are subsequently cooled to room temperature in at least one step.

In one development of the invention, the substrate is previously prepared with a precursor layer and, above the latter, with a layer of chalcogens prior to introduction into the furnace.

This chalcogen layer is preferably produced by vapour deposition of selenium onto the precursor layer.

The invention is furthermore characterized in that the precursor layers are produced by successive sputtering of copper, indium and gallium.

For this purpose, substrates comprising glass are firstly provided with a first molybdenum layer by sputtering, onto which layer are then sputtered a second layer composed of copper/gallium (CuGA) from a composite target and, finally, a third layer composed of indium from an indium target under a high vacuum.

Furthermore, the heating of the substrates and the conversion of the precursor layers are performed in the absence of oxygen and hydrogen, or with a lowest possible oxygen partial pressure.

After the conclusion of the conversion of the metallic precursor layers into CIGS layers, the substrate can also be cooled in a step-response function.

In a further configuration of the invention, the substrates are transported step by step through the segmented furnace and are in each case heated to a higher temperature in successive segments, the predetermined residence duration in the individual segments being identical.

The residence duration can be 60 seconds.

Furthermore, the substrates are heated in the segments from room temperature, that is to say from an ambient temperature of approximately 20°C, with a decreasing temperature difference up to the end and reaction temperature, the temperature gradient varying from segment to segment in such a way that the heating rate is approximately twice as high in the second section as in the preceding section and the succeeding section, in which the end and reaction temperature is reached.

As an alternative, the heating process can be effected in each section in a step-response function to the respective desired temperature.

The heating can be performed in stages from room temperature to 150°C, 400°C and 500°C - 600°C, in which case the 550°C mark must not be exceeded as end temperature.

The heating in the individual sections is performed over in each case an identical time duration, which can be 60 seconds.

The substrates are cooled for example at a cooling rate of 8°C/sec.

Furthermore, the pressure in the process chamber during the conversion process can be set to atmospheric pressure, e.g. to approximately 1000 hPa.

A further configuration of the invention is characterized in that in the segment with the highest target temperature, a mixture of a chalcogen vapour/carrier gas mixture is brought over the surface of the substrate.

The chalcogen vapour/carrier gas mixture can also be supplied from a heated source outside the muffle furnace.

As an alternative, the chalcogen vapour/carrier gas mixture can contain vaporous chalcogen evaporated from the substrate in preceding segments.

In a particular configuration of the invention, the chalcogen vapour/carrier gas mixture is produced from a mixture of chalcogen evaporated from the substrates in a preceding segment and additionally supplied chalcogen vapour from a source.

A mixture of selenium vapour and nitrogen can be used as chalcogen vapour/carrier gas mixture.

The object on which the invention is based is also achieved by means of an apparatus comprising the features of claim 15.

Therein, the furnace is divided into a plurality of successive sections having different temperature regions, which are connected to one another by a continuous furnace channel, in which case, between an inlet-side section and an outlet-side section, further sections that can be heated independently of one another are arranged as heating zones and afterwards at least one section is arranged as a cooling zone. In the furnace channel that connects the sections there is situated a thermally and mechanically low-mass transport device for the step-by-step and simultaneous transport of all the substrates situated in the sections at a high speed from one section to the respective next section. The furnace is equipped with inlet- and outlet-side locks.

Furthermore, the inlet-side section can be embodied as lock introduction chamber and the outlet-side section can be embodied as output lock.

In one development of the invention, ambient pressure should prevail in the furnace.

The transport device comprises graphite rollers which are mounted rotatably in the furnace and on which the substrates are guided displaceably in segments longitudinally through the furnace channel, and in that a displaceable and rotatable push rod concomitantly provided with transport lugs with the spacing pitch of the substrates is mounted between the rollers, the transport lugs of which, as viewed in the transport direction, can in each case be brought into engagement with the trailing edge of the substrates, it being possible for the leading edge of the substrates to be brought into engagement with the transport lug of the respective preceding substrate for braking purposes. The transport lugs can be brought into engagement by rotation of the push rod and, after transport travel has been effected, can be pivoted into a position out of engagement with the substrates.

The residence duration of the substrates in the individual segments is identical and can be 60 seconds, for example.

A further development of the invention is characterized in that the furnace is subdivided into six segments, it being possible for the segments to be temperature-regulated to different, respectively successively higher target temperatures; and a chalcogen vapour/carrier gas mixture with a predetermined concentration being situated in the segment having the highest target temperature.

The target temperatures are graded in the individual segments in such a way that a target temperature of for example 150°C can be set in the first segment, a target temperature of 400°C can be set in the following segment, and a target temperature of 550°C can be set in the next segment, for the substrates.

Furthermore, the segment following the segment having the highest target temperature is connected to an exhaust gas channel for discharging and conditioning excess chalcogen vapour/carrier gas mixture.

Finally, the inlet- and outlet-side locks comprise gas curtains that ensure that the interior of the furnace is sufficiently sealed with respect to oxygen and hydrogen.

A solar module comprising a CIGS layer on a substrate, can be produced by providing a substrate prepared with a metallic precursor layer, heating the substrate in a plurality of stages to in each case a higher target temperature with different temperature gradients up to the conversion temperature of 550°C for converting the precursor layer into a CIGS layer with a vaporous chalcogen applied to the precursor layer.

The cooling can be effected for example in a step-response function or at a cooling rate of approximately 8-10°C/second.

The temperature gradient varies from segment to segment in such a way that the heating rate is approximately twice as high in the second section as in the preceding section and the succeeding section, in which the end and reaction temperature is reached.

The method according to the invention achieves a particularly uniform lattice structure of the CIGS layer in association with a higher efficiency of the solar module.

Preferably, vaporous selenium, sulphur, tellurium, compounds thereof among one another or with other substances or mixtures thereof are used as the chalcogen.

Furthermore, the metallic precursor layers contain copper, indium and gallium.

The invention realizes an accelerated method for converting the metallic layers into semiconducting layers.

It has been shown that the processes for converting the metallic layers into semiconducting layers depend both on the temperature and on the ambient pressure. Although it is generally known that chemical reactions - the conversion of the metallic layers to semiconducting semiconductor layers being such a chemical reaction - are a function of temperature and of pressure, the temperature dependence of the reactions has always been utilized heretofore for the present problem, which can be regarded as an indication that experts have not taken into account, that is to say have overlooked, the variation of the process pressure with regard to the conversion of metallic layers into semiconducting layers.

Advantages of the present method are a faster conversion of metallic layers into semiconducting layers, shorter cycle times in the industrial process and a more cost-effective fabrication since lower capital expenditure arises owing to fewer installations required.

The present invention concerns a novel thermal process for any desired substrates in which metallic layers, which can contain copper, gallium and indium, are converted with selenium and/or sulphur into semiconducting semiconductor layers. The conversion is effected at ambient or atmospheric pressure.

The special feature of the present invention is that rather than working under vacuum, work is performed under atmospheric conditions, or under increased process pressure, whereby the speed of the chemical reactions involved in the conversion is considerably increased.

The invention will be explained in more detail below on the basis of an exemplary embodiment. The associated drawings showing not true to scale:
- Figure 1: a schematic illustration of a furnace that is divided into a plurality of segments and is suitable for the step-by-step transport of substrates;

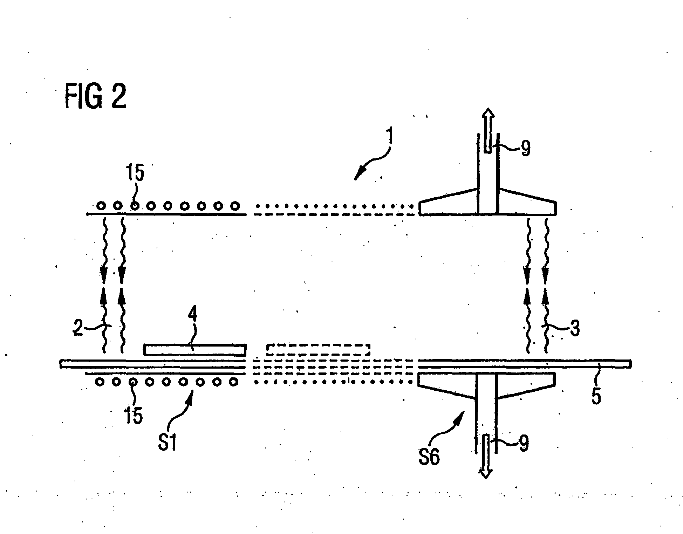

- Figure 2: schematically illustrated details of the furnace according to Figure 1; and
- Figure 3: a schematic plan view of the transport device.

The method according to the invention for thermally converting metallic layers, which can contain copper, gallium or indium, on substrates into semiconducting CIGS layers can be performed per se in any desired furnace 1, e.g. a muffle furnace, which has to meet the following preconditions.

The furnace 1 must comprise heatable or coolable segments S1...Sn, of which the heatable segments S1...Sn must be suitable at least in part for carrying out fast thermal processes.

Furthermore, the furnace 1 must be able to be operated under atmospheric pressure and must be provided with suitable devices for feeding in and discharging gas.

A further important recondition is that care is taken to ensure that the interior of the furnace 1, over the entire length thereof, is constantly kept largely free of oxygen and, if appropriate, also of hydrogen.

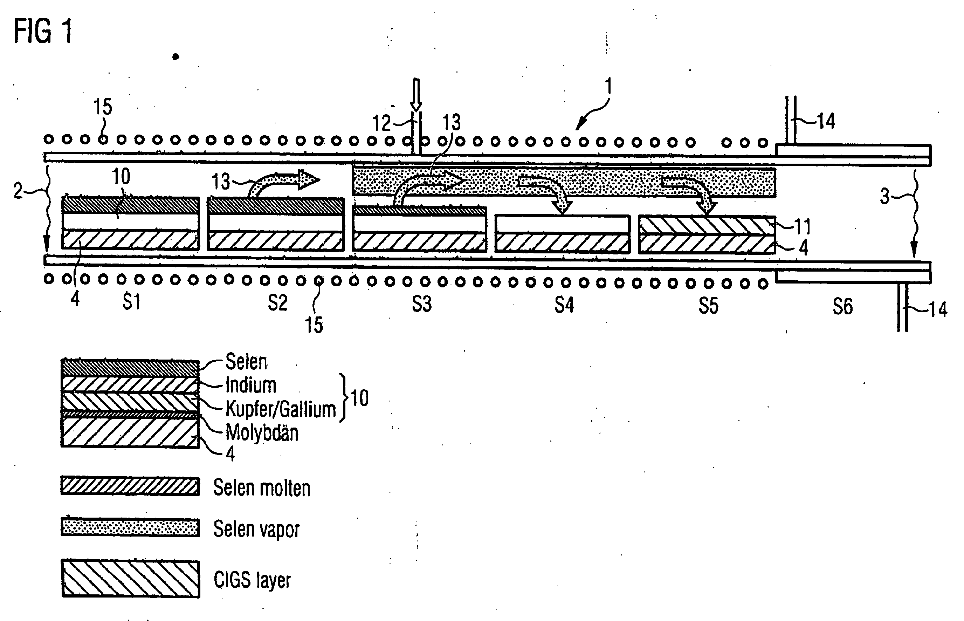

The furnace 1 overall is composed of graphite, has a double-walled high-grade steel enclosure and, in accordance with Figure 1, is subdivided into six successive segments S1...S6.

In order to keep the interior of the furnace 1 free of oxygen and hydrogen, locks 2, 3 in the form of gas curtains composed of an inert gas are provided on the inlet and outlet sides. The oxygen partial pressure in the furnace 1 must in any event be kept extremely low. The locks 2, 3 simultaneously enable substrates 4 to be transported by means of a transport device 5 through the individual segments S1...S6 of the furnace 1 in a continuous method.

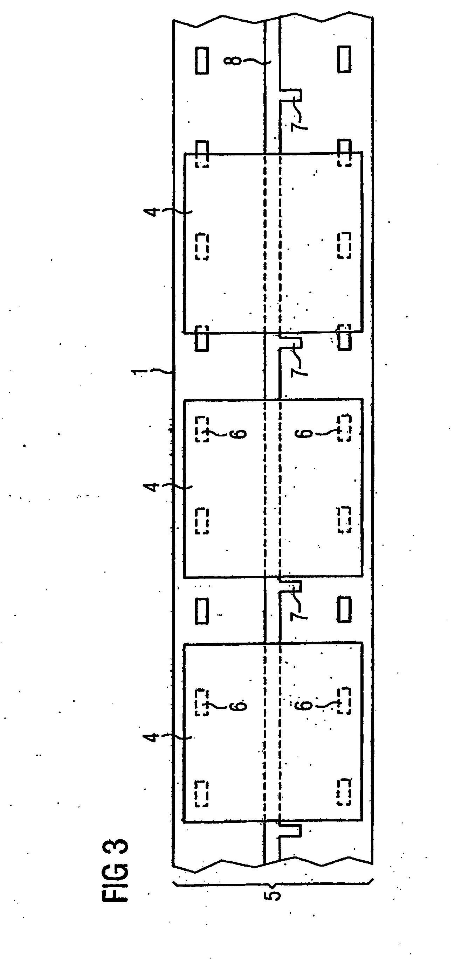

The transport device 5 in accordance with Figure 3 can comprise graphite rollers 6 which are mounted rotatably in the furnace 1 and on which the substrates 4 are pushed in segments longitudinally through the furnace 1. A displaceable and rotatable push rod 8 concomitantly provided with transport lugs 7 with the spacing pitch of the substrates 4 and equipped with a drive (not illustrated) is provided for this purpose.

In order to carry out the transport of all the substrates 4 simultaneously, the transport lugs 7, before each transport travel, are brought into engagement with the substrates 4 by rotation of the push rod 8 upwards and all the substrates 4 are accelerated simultaneously. At the end of each transport travel, the substrates 4 are braked, their leading edge engaging with the transport lug 7 of the respective preceding substrate 4. After the transport travel has been effected, the transport lugs 7 are pivoted away again, whereupon the transport rod 8 is moved back to its starting position again.

The residence duration of the substrates 4 in the individual segments S1...Sn is in each case identical and is 60 seconds, for example.

The gas guiding in the interior of the furnace 1 is configured in such a way that all the gases and vapours supplied to the furnace 1 or arising in the latter are guided from the segment S1 via the following segments S2...Sn to an exhaust gas channel 9. Gas transport in the opposite direction is precluded.

In accordance with Figure 1, the furnace 1 contains six segments connected to one another via a continuous furnace channel, the segment S1 being temperature-regulated to an internal temperature of approximately 150°C, such that the substrates 4 introduced into the segment 1 are immediately subjected to a first heating process. In this segment, the oxygen and hydrogen entrained into the segment S1 with the transport of the substrates 4 are also removed completely from the segment S1.

In the next segment S2, the substrates are heated to a temperature of 400°C, and to approximately 500°C in the following segment S3, the temperature gradient varying from segment to segment in such a way that the heating rate is significantly higher, e.g. approximately twice as high, in the second section S2 than in the preceding section S1 and the succeeding section S3, until finally the end and reaction temperature is reached in the section S4 with 550°C. This reaction temperature is maintained in the succeeding section S5.

Figure 1 illustrates adjacent to the section S5 a section S6, illustrated with an active cooling device 14 in the form of a water cooling. Since, in the event of excessively rapid cooling, thermally induced problems can occur with large-area substrates, it is also possible to insert an intermediate section without heating before the section S6, or to omit the cooling device of the section S6.

As will be explained in more detail below, metallic precursor layers 10 composed of copper, gallium and indium are situated on a molybdenum layer on the previously prepared substrates 4.

For this purpose, substrates 4 comprising glass are firstly provided with a first molybdenum layer by sputtering, onto which layer are then sputtered a second layer composed of copper/gallium (CuGA) from a composite target and, finally, a third layer composed of indium from an indium target under a high vacuum (Figure 1).

The precursor layers are converted into a semiconducting CIGS layer in the segments S3-S5. This process requires firstly a temperature of 550°C in the segment S3 S5, and the presence of vaporous chalcogen, e.g. vaporous selenium.

For this purpose, by way of example, the substrates 4 are heated from 400°C to approximately 500°C in the segment S3 and to 550°C - 600°C in the segment S4 and a chalcogen vapour/carrier gas mixture is simultaneously conducted into the segments S3-S5 with sufficient concentration onto the surface of the substrates 4. In this case, the metallic precursor layer is converted abruptly into the desired semiconducting CIGS layer, after which the excess chalcogen vapour/carrier gas mixture is disposed of via the exhaust gas channel 9.

The heating of the segments S1-S5 can be effected externally with the aid of an electrical or other heating 15 illustrated schematically in Figure 1. Within the furnace 1, the heating is then effected by the heated graphite walls, or in the segment S6, or in further segments the cooling is effected by, for example, cooled graphite walls of the furnace channel.

There are various possibilities for producing the necessary chalcogen concentration in the segments S3-S5. Thus, a chalcogen vapour/carrier gas mixture can be provided from an additional source 12. Another possibility is that the substrates, prior to introduction into the furnace 1, have already been provided with a vapour-deposited chalcogen layer, which then evaporates in the segments S2 and S3 and is conducted by means of the internal gas guiding in the furnace 1 as chalcogen vapour 13, e.g. selenium vapour, into segment S4, and S5, where, if appropriate, residual chalcogen still present finally evaporates and is likewise available there for the conversion process.

The conversion process is referred to as selenium annealing in the case where selenium vapour is used as the chalcogen. As an alternative, the two variants can also be combined with one another. An additional chalcogen vapour/carrier gas mixture can simultaneously be introduced into the segment S2, S3 or S3 if the concentration of the chalcogen evaporated from the substrates is insufficient (Figure 1).

After a predetermined residence duration in the segment S5, generally 60 seconds, the substrates 4 are pushed into a further segment S6, in which cooling as rapidly as possible is effected by a cooling device 14, whereupon the substrates 4 are then discharged through a lock or pushed into a further segment S and from there discharged through a lock with a temperature of less than 100°C.

It goes without saying that the furnace 1 can also contain more than six segments, and that other temperature stipulations can also be set/chosen in the individual segments, provided that a temperature of 500-600°C is reached in the segment in which the metallic precursor layer is intended to be converted into the desired CIGS layer. A temperature of 550°C is a minimum here.

The pressure in the furnace 1 can be at ambient pressure, e.g. at 1000 hPa.

What is crucial for the process control is the interplay between the transport of the substrates 4 through the furnace 1 from segment to segment through the furnace channel. In this case, it must be ensured that enough vaporous chalcogens, e.g. selenium vapour, are present in the furnace atmosphere above the substrates 4 in the segment S4 when the reaction temperature is reached. Only then can an abrupt conversion of copper/gallium and indium of the precursor layer 10 to CIGS take place. This is also achieved by each segment S1-S6 being equipped at any time with one substrate 4 or a plurality of substrates alongside one another, such that this can be designated as quasi-continuous operation of the furnace 1.

### List of reference symbol

- 1: Furnace
- 2: Inlet-side flow lock
- 3: Outlet-side flow lock
- 4: Substrate
- 5: Transport device
- 6: Graphite roller
- 7: Transport lug*
- 8: Push rod
- 9: Exhaust gas channel
- 10: Precursor layer
- 11: CIGS layer
- 12: Source
- 13: Chalcogen vapour
- 14: Cooling device
- 15: Heating

## Claims

1. Method for thermally converting metallic precursor layers on a substrate into semiconducting layers, wherein the substrates (4) prepared at least with a metallic precursor layer (10) are heated in a furnace (1), which is segmented into a plurality of temperature regions, to an end temperature between 400 °C and 600 °C and are converted into semiconducting layers whilst maintaining the end temperature in an atmosphere comprising vaporous chalcogens,
**characterized**
- **in that** the substrates (4) are prepared with the metallic precursor layer (10) before they are heated in the furnace (1),
- **in that** the substrates (4) are heated in the furnace (1) at a pressure at approximately atmospheric ambient pressure in a plurality of steps in each case to a predetermined temperature up to the end temperature,
- **in that** the atmosphere in which the substrates (4) are converted into semiconducting layers comprises a mixture of a carrier gas and vaporous chalcogens, and
- **in that** a push rod (8) is rotated in order to bring transport lugs (7) of the push rod (8) into engagement with the substrates (4), the push rod (8) is then accelerated and in doing so the substrates (4) are transported simultaneously through the segmented furnace (1).

2. Method according to Claim 1,
**characterized in that**
the substrates (4) are subsequently cooled to room temperature in at least one step.

3. Method according to Claim 1,
**characterized in that**
the substrate (4) is previously prepared with a precursor layer (10) and, above the latter, with a layer of chalcogens prior to introduction into the furnace (1).

4. Method according to Claim 3,
**characterized in that**
the chalcogen layer is produced principally by vapour deposition of selenium onto the precursor layer (10).

5. Method according to Claims 1 to 4,
**characterized in that**
the precursor layer (10) is produced in a preceding process by successive sputtering of copper, indium and gallium.

6. Method according to Claim 5,
**characterized in that**
substrates (4) comprising glass are firstly provided with a first molybdenum layer by sputtering, onto which layer are then sputtered a second layer composed of copper/gallium from a composite target and, finally, a third layer composed of indium from an indium target under high vacuum.

7. Method according to Claim 1,
**characterized in that**
the heating of the substrates (4) and the conversion of the precursor layer (10) into a CIGS layer are performed in the absence of oxygen and hydrogen.

8. Method according to any of Claims 1 to 7,
**characterized in that**
the substrates (4) are transported step by step through a segmented furnace (1) and are in each case heated to a higher temperature in successive segments (S1 ... Sn), the predetermined residence duration in the individual segments (S1 .... Sn) being identical.

9. Method according to any of Claims 1 to 8,
**chararacterized in that**
the heating is effected in stages from room temperature to 150 °C, 400 °C and 500 °C to 600 °C, or at least 550 °C.

10. Method according to any of Claims 1 to 9,
**characterized in that**
the heating to the next higher temperature in the individual sections is effected over in each case an identical time duration, which can be 60 seconds.

11. Method according to any of Claims 1 to 10,
**characterized in that**
atmospheric pressure is set, e. g. to 1000 hPa, in the furnace (1) during the conversion process.

12. Method according to any of Claims 1 to 11,
**characterized in that**
in the segment with the highest target temperature, a mixture of a chalcogen vapour/carrier gas mixture is brought over the surface of the substrate, and **in that** the chalcogens vapour/carrier gas mixture is supplied from a source.

13. Method according to any of Claims 1 to 12,
**characterized in that**
in the segment with the highest target temperature, a mixture of a chalcogen vapour/carrier gas mixture is brought over the surface of the substrate, and **in that** the chalcogen vapour/carrier gas mixture contains vaporous chalcogen evaporated from the substrate in preceding segments.

14. Method according to any of Claims 1 to 13,
**characterized in that**
a mixture of selenium vapour and nitrogen is used as chalcogen vapour/carrier gas mixture.

15. Apparatus for carrying out the method in a furnace, wherein the furnace (1) is divided into a plurality of successive sections (S1 ... Sn) having different temperature which are connected to one another by a continuous furnace channel, in which case, between an inlet-side section (S1) and an outlet-side section (Sn), further sections that can be heated independently of one another are arranged as heating zones and a transport device (5) for simultaneous transport of all substrates (4) situated in the sections (S1 ... Sn) from one section (S1 ... Sn) to the respective next section (S1 ... Sn) is provided,
**characterized**
- **in that** at least one section is arranged as a cooling zone after the further sections,
- **in that** the furnace (1) is equipped with inlet- and outlet-side locks (2, 3),
- **in that** the transport device (5) has a particularly low thermal and mechanical mass and is situated in the furnace channel that connects the sections (S1 -. Sn),
- **in that** the substrates (4) can be transported step-by-step by means of the transport device (5),
- **in that** the transport device (5) comprises graphite rollers (6) which are mounted rotatably in the furnace (1) and on which the substrates (4) are guided displaceably in segments longitudinally through the furnace (1), and
- **in that** for transport of the substrates (4) at a particular high speed a displaceable and rotatable push rod (8) concomitantly provided with transport lugs (7) with the spacing pitch of the substrates (4) is mounted between the rollers (6), the transport lugs (7) of which, as viewed in the transport direction, can in each case be brought into engagement with the trailing edge of the substrates (4).

16. Apparatus according to Claim 15,
**characterized in that**
the inlet-side section is embodied as a lock introduction chamber and the outlet-side section is embodied as output lock.

17. Apparatus according to any of Claims 15 to 16,
**characterized in that**
ambient pressure prevails in the furnace (1).

18. Apparatus according to any of Claims 15 to 17,
**characterized in that**
the transport lugs (7) can be brought into engagement by rotation of the push rod (8) and, after transport travel has been effected, can be pivoted into a position out of engagement with the substrates (4).

19. Apparatus according to any of Claims 15 to 18,
**characterized in that**
the segment (S6) following the segment having the highest desired temperature is connected to an exhaust gas channel (9) for discharging excess chalcogen vapour/carrier gas mixture.

20. Apparatus according to any of Claims 15 to 19,
**characterised in that**
the inlet- and outlet-side locks (2, 3) comprise gas curtains.

## Patentansprüche

1. Verfahren zur thermischen Umsetzung metallischer Vorläufeschichten auf einem Substrat in Halbleiterschichten, bei welchem die mit zumindest einer metallischen Vorläuferschicht (10) versehenen Substrate (4) in einem Ofen (1), welcher in eine Vielzahl von Temperaturregionen unterteilt ist, auf eine Endtemperatur zwischen 400 °C und 600 °C erwärmt und in Halbleiterochichten umgesetzt werden, während die Endtemperatur in einer Chalkogendämpfe aufweisenden Atmosphäre aufrechterhalten wird,
**dadurch gekennzeichnet,**
- **dass** die Substrate (4) mit der metallischen Vorläuferschicht (10) versehen werden, bevor sie in dem Ofen (1) erwärmt werden,
- **dass** die Substrate (4) in dem Ofen (1) bei einem Druck von ungefähr atmosphärischem Umgebungsdruck in einer Vielzahl von Schritten jeweils auf eine vorgegebene Temperatur bis zu der Endtemperatur erwärmt werden,
- **dass** die Atmosphäre, in welcher die Substrate (4) in Halbleiterschichten umgesetzt werden, eine Mischung aus einem Trägergas und Chalkogendämpfen aufweist, und
- **dass** eine Schubstange (8) gedreht wird, um Transportnasen (8) der Schubstange (8) mit den Substraten (4) in Eingriff zu bringen, die Schubstange (8) sodann beschleunigt wird und auf diese Weise die Substrate (4) gleichzeitig durch den segmentierten Ofen (1) transportiert werden.

2. Verfahren nach Anspruch 1,
**dadurch gekennzeichnet,**
**dass** die Substrate (4) nachfolgend in wenigsten einem Schritt auf Raumtemperatur abgekühlt werden.

3. Verfahren nach Anspruch 1,
**dadurch gekennzeichnet,**
**dass** das Substrat (4) im Vorfeld mit einer Vorläuferschicht (10) und über der letztgenannte vor der Einführung in den Ofen (1) mit einer Schicht aus Chalkogenen präpariert wird.

4. Verfahren nach Anspruch 1,
**dadurch gekennzeichnet,**
**dass** die Chalkogenschicht im Wesentlichen hergestellt wird mittels Dampfabscheidung von Selen auf die Vorläuferschicht (10).

5. Verfahren nach Ansprüchen 1 bis 4,
**dadurch gekennzeichnet,**
**dass** die Vorläuferschicht (10) in einem vorausgehenden Arbeitsgang hergestellt wird mittels aufeinander folgendes Sputtern von Kupfer, Indium und Gallium.

6. Verfahren nach Anspruch 5,
**dadurch gekennzeichnet,**
**dass** Glas aufweisende Substrate (4) zuerst mittels Sputterns mit einer ersten Molyhdänachicht versehen werden, auf diese Schicht sodann eine zweite Schicht gebildet aus Kupfer/Gallium von einem Mischtarget und schließlich eine dritte Schicht gebildet aus Indium von einem Indiumtarget unter Hochvakuum aufgesputtert werden.

7. Verfahren nach Anspruch 1,
**dadurch gekennzeichnet,**
**dass** das Erwärmen der Substrate (4) und die Umsetzung der Vorläuferschicht (10) in eine CIGS-Schicht in Anwesenheit von Sauerstoff und Wasserstoff durchgeführt werden.

8. Verfahren nach einem der Ansprüche 1 bis 7,
**dadurch gekennzeichnet,**
**dass** die Substrate (4) schrittweise durch einen segmentierten Ofen (1) transportiert und in aufeinander folgenden Abschnitten (S1 ... Sn) jeweils auf eine höher Temperatur erwärmt werden, wobei die vorbestimmte verweildauer in den einzelnen Abschnitten (S1 ... Sn) identisch ist.

9. Verfahren nach einem der Ansprüche 1 bis 8,
**dadurch gekennzeichnet,**
**dass** das Heizen schrittweise von Raumtemperatur auf 100 °C,
400 °C und 500 °C bis 600 °C oder zumindest 550 °C erfolgt.

10. Verfahren nach einem der Ansprüche 1 bis 9,
**dadurch gekennzeichnet,**
**dass** das Erwärmen auf die nächsthöhere Temperatur in den jeweiligen Abschnitten über eine in jedem Fall identische Zeitdauer hinweg erfolgt, welche 60 Sekunden sein kann.

11. Verfahren nach einem der Ansprüche 1 bis 10,
**dadurch gekennzeichnet,**
**dass** in dem Ofen (1) während des Umsetzungsprozesses Atmosphärendruck, beispielsweise 1000 hPa, eingestellt wird.

12. Verfahren nach einem der Ansprüche 1 bis 11,
**dadurch gekennzeichnet,**
**dass** in dem Abschnitt mit der höchsten Zieltemperatur ein Gemisch von einem Chalkogendampf-/Trägergas-Gemisch über die Oberfläche des Substrates gebracht wird und dass das Chalkogendampf-/Trägergas-Gemisch aus einer Quelle zugeführt wird.

13. Verfahren nach einem der Ansprüche 1 bis 12,
**dadurch gekennzeichnet,**
**dass** in dem Abschnitt mit der höchsten Zieltemperatur ein Gemisch von einem Chalkogendampf-/Trägergas-Gemisch über die Oberfläche des Substrates gebracht wird und dass das Chalkogendampf-/Trägergas-Gemisch dampfförmiges Chalkogen enthält, welches von dem Substrat in vorangegangenen Abschnitten verdampft ist.

14. Verfahren nach einem der Ansprüche 1 bis 13,
**dadurch gekennzeichnet,**
**dass** eine Mischung aus Selendampf und Stickstoff als Chalkogendampf-/Trägergas-Gemisch verwendet wird.

15. Vorrichtung zur Ausführung des Verfahrens in einem Ofen, bei welcher der Ofen (1) in eine Vielzahl aufeinanderfolgender Abschnitte (S1 ... Sn) mit unterschiedlichen Temperaturen unterteilt ist, welche miteinander mittels eines durchgängigen Ofenkanals verbunden sind, wobei zwischen einem eingangsseitigen Abschnitt (S1) und einem ausgangsseitigen Abschnitt (Sn) weitere, unabhängig voneinander erwärmbare Abschnitte als Heizzonen angeordnet sind und eine Transportvorrichtung (5) zum gleichzeitigen Transport aller in den Abschnitten (S1 ... Sn) befindlichen Substrate (4) von einem Abschnitt (S1 ... Sn) au dem jeweils nächsten Abschnitt (S1 ... Sn) vorgesehen ist,
**dadurch gekennzeichnet,**
- **dass** nach den weiteren Abschnitten wenigstens ein Abschnitt als Kühlzone angeordnet ist,
- **dass** der Ofen (1) mit eingangs- und ausgangsseitigen Gasschleusen (2, 3) ausgestattet ist,
- **dass** die Transportvorrichtung (5) eine besonders geringe thermische und mechanische Masse aufweist und in dem Ofenkanal angeordnet ist, welcher die Abschnitte (S1 ... Sn) verbindet,
- **dass** die Substrate (4) mittels der Transportvorrichtung (5) schrittweise transportierbar sind,
- **dass** die Transportvorrichtung (5) Graphitrollen (6) aufweist, welche in dem Ofen (1) drehbar angebracht sind und auf welchen die Substrate (4) in Abschnitten versetzbar in Längsrichtung durch den Ofen geführt werden, und
- **dass** zum Transport der Substrate (4) mit einer besonders hohen Geschwindigkeit eine verschiebbare und drehbare Schubstange (8), welche zudem im Abstand der Substrate (4) mit Transportnasen (7) versehen ist, zwischen den Rollen (6) angebracht ist, wobei deren Transportnasen (7), in der Transportrichtung betrachtet, jeweils mit der Hinterkante der Substrate (4) in Eingriff gebracht werden können.

16. Vorrichtung nach Anspruch 15,
**dadurch gekennzeichnet,**
**dass** der eingangsseitige Abschnitt als Eingangsechleusenklammer und der ausgangsseitige Abschnitt als Ausgangsschleuse auageführt sind.

17. Vorrichtung nach einem der Ansprüche 15 bis 16,
**dadurch gekennzeichnet,**
**dass** in dem Ofen (1) Umgebungsdruck vorherrscht.

18. Vorrichtung nach einem der Ansprüche 15 bis 17,
**dadurch gekennzeichnet,**
**dass** die Transportnasen (7) durch Drehen der Schubstange (8) in Eingriff bringbar sind und, nachdem eine Transportbewegung erfolgt ist, in einer Position verdrehbar sind, in welcher sie sich nicht im Eingriff mit den Substraten (4) befindet.

19. Vorrichtung nach einem der Ansprüche 15 bis 18,
**dadurch gekennzeichnet,**
**dass** der auf den Abschnitt mit der höchstens Zieltemperatur folgende Abschnitte (S6) zum Austrag von überschüssigem Chalkogendampf-/Trägergas-Gemisch mit einem Abgaskanal (9) verbunden ist.

20. Vorrichtung nach einem der Ansprüche 15 bis 19,
**dadurch gekennzeichnet,**
**dass** die eingangs- und ausgangsseitigen Gasschleusen (2, 3) Gasvorhänge aufweisen.

## Revendications

1. Procédé de conversion thermique de couches de précurseurs métalliques sur un substrat en couches semiconductrices, les substrats (4) préparés au moins avec une couche de précurseurs métalliques (10) étant chauffés dans un four (1), qui est segmenté en une pluralité de zones de températures, à une température finale entre 400 °C et 600 °C et étant convertis en couches semiconductrices tout en maintenant la température finale dans une atmosphère comprenant des chalcogènes vaporeux, **caractérisé**
- **en ce que** les substrats (4) sont préparés avec la couche de précurseurs métalliques (10) avant d'être chauffés dans le four (1),
- **en ce que** les substrats (4) sont chauffés dans le four (1) à une pression qui est approximativement la pression atmosphérique ambiante en une pluralité d'étapes dans chaque cas à une température prédéterminée allant jusqu'à la température finale,
- **en ce que** l'atmosphère dans laquelle les substrats (4) sont convertis en couches semiconductrices comprend un mélange de gaz porteur et de chalcogènes vaporeux et
- **en ce qu'**une tige de poussée (8) tourne pour mettre des oeillets de transport (7) de la tige de poussée (8) en prise avec les substrats (4), la tige de poussée (8) étant ensuite accélérée et ce faisant les substrats (4) sont transportés simultanément à travers le four segmenté (1).

2. Procédé selon la revendication 1, **caractérisé en ce que** les substrats (4) sont ensuite refroidis à la température ambiante en au moins une étape.

3. Procédé selon la revendication 1, **caractérisé en ce que** le substrat (4) est préalablement préparé avec une couche de précurseurs (10) et avec une couche de chalcogènes au-dessus de cette darniére avant l'introduction dans le four (1).

4. Procédé selon la revendication 3, **caractérisé en ce que** la couche de chalcogènes est produite principalement par dépôt en phase vapeur de sélénium sur la couche de précurseurs (10).

5. Procédé selon les revendications 1 à 4, **caractérisé en ce que** la couche de précurseurs (10) est produite dans un processus précédent par pulvérisation successive de cuivre, d'indium et de gallium.

6. Procédé selon la revendication 5, **caractérisé en ce que** des substrats (4) comprenant du verre sont d'abord fournis avec une première couche de molybdène par pulvérisation, couche sur laquelle sont ensuite pulvérisées une seconde couche composée de cuivre/gallium d'une cible composites et finalement une troisième couche composée d'indium d'une cible d'indium sous vide poussé

7. Procédé selon la revendication 1, **caractérisé en ce que** le chauffage des substrats (4) et la conversion de la couche de précurseurs (10) en couche CIGS sont réalisés en l'absence d'oxygène et d'hydrogène.

8. Procédé selon l'une quelconque des revendications 1 à 7, **caractérisé en ce que** les substrats (4) sont transportés étape par étage à travers un four segmenté (1) et sont dans chaque cas chauffé à une température plus élevée dans des segments successifs (S1 ... Sn), la durée de séjour prédéterminée dans les segments individuels (S1 ... Sn) étant identique.

9. Procédé selon l'une quelconque des revendications 1 à 8, **caractérisé en ce que** le chauffage est effectué en étapes de la température ambiante à 150 °C, 400 °C et 500 °C à 600 °C ou au moins à 550 °C.

10. Procédé selon l'une quelconque des revendications 1 à 9, **caractérisé en ce que** le chauffage à la prochaine température plus élevée dans les sections individuelles est effectué pendant, dans chaque cas, une durée de temps identique qui peut être de 60 secondes.

11. Procédé selon l'une quelconque des revendications 1 à 10, **caractérisé en ce que** la pression atmosphérique est fixée, par exemple à 1000 hPa, dans le four (1) pendant le processus de conversion.

12. Procédé selon l'une quelconque des revendications 1 à 11, **caractérisé en ce que**, dans le segment avec la température cible la plus élevée, un mélange de vapeur de chalcogènes et de gaz porteur est amené sur la surface du substrat et **en ce que** le mélange de vapeur de chalcogènes et de gaz porteur est fourni à partir d'une source.

13. Procédé selon l'une quelconque des revendications 1 à 12, **caractérisé en ce que**, dans le segment avec la température cible la plus élevée, un mélange de vapeur de chalcogènes et de gaz porteur est amené sur la surface du substrat et **en ce que** le mélange de vapeur de chalcogènes et de gaz porteur contient des chalcogènes vaporeux évaporés du substrat dans des segments précédents.

14. Procédé selon l'une quelconque des revendications 1 à 13, **caractérisé en ce qu'**un mélange de vapeur de sélénium et de nitrogène est utilisé comme mélange de vapeur de chalcogènes et de gaz porteur.

15. Appareil pour exécuter le procédé dans un four, le four (1) étant divisé en une pluralité de sections successives (S1 ... Sn) ayant différentes températures qui sont connectées l'une à l'autre par un canal de four continu, dans lequel cas d'autres sections qui peuvent être chauffées indépendamment l'une de l'autre sont arrangées entre une section côté entrée (S1) et une section côté sortie (Sn) en tant que zones de chauffage et un dispositif de transport (5) étant prévu pour le transport simultané de tous les substrats (4) situés dans les sections (S1 ... Sn) d'une section (S1 ... Sn) à la section prochaine respective (S1 ... Sn), **caractérisé**
- **en ce qu'**au moins une section est arrangée comme zone de refroidissement après les autres sections,
- **en ce que** le four (1) est équipé de verrouillages côté entrée et de verrouillages côté sortie (2, 3),
- **en ce que** le dispositif de transport (5) a une masse thermique et mécanique particulièrement basse et est situé dans le canal de four qui relie les sections (S1 ... Sn),
- **en ce que** les substrats (4) peuvent être transportés étape par étape au moyen du dispositif de transport (5),
- **en ce que** le dispositif de transport (5) comprend des roues en graphite (6) qui sont montées rotatives dans le four (1) et sur lequel les substrats (4) sont guidés de manière déplaçable en segments dans le sens longitudinal à travers le four (1) et
- **en ce que**, pour le transport des substrats (4) à une vitesse particulièrement élevée, une tige de poussée déplaçable et rotative (8) prévue simultanément
- avec des oeillets de transport (7) avec le pas d'espacement des substrats (4) est montée entre les roues (6), tige dont les oeillets de transport (7) peuvent, dans chaque cas, être mis en prise avec l'extrémité arrière des substrats (4), ceci étant vu dans le sens du transport.

16. Appareil selon la revendication 15, **caractérisé en ce que** la section côté entrée est incorporée en tant que chambre d'introduction de verrouillage et la section côté sortie est incorporée comme verrouillage de sortie.

17. Appareil selon l'une quelconque des revendications 15 à 16, **caractérisé en ce que** la pression ambiante règne dans le four (1).

18. Appareil selon l'une quelconque des revendications 15 à 17, **caractérisé en ce que** les oeillets de transport (7) peuvent être mis en prise par rotation de la tige de poussée (8) et, après que le déplacement de transport ait été effectué, être pivotés dans une position dégagée de la prise avec les substrats (4).

19. Appareil selon l'une quelconque des revendications 15 à 18, **caractérisé en ce que** le segment (S6) qui suit le segment qui a la température la plus élevée souhaitée est relié à un conduit d'évacuation de gaz (9) pour évacuer l'excédent de mélange de vapeur de chalcogènes et de gaz porteur.

20. Appareil selon l'une quelconque des revendications 15 à 19, **caractérisé en ce que** les verrouillages côté entrée et côté sortie (2, 3) comprennent des rideaux de gaz.
